Europäisches Patentamt

European Patent Office

Office européen des brevets

(11) Publication number: **0 349 904 B1**

# EUROPEAN PATENT SPECIFICATION

(45) Date of publication of patent specification: **23.02.94**  (51) Int. Cl.⁵: **B22D 11/01**, B22D 11/10

(21) Application number: **89111868.9**

(22) Date of filing: **29.06.89**

(54) **Apparatus for casting silicon.**

(30) Priority: **05.07.88 JP 167194/88**

(43) Date of publication of application:
**10.01.90 Bulletin 90/02**

(45) Publication of the grant of the patent:
**23.02.94 Bulletin 94/08**

(84) Designated Contracting States:
**DE FR GB**

(56) References cited:
**EP-A- 0 109 131**
**FR-A- 2 104 964**
**US-A- 4 572 812**

(73) Proprietor: **SUMITOMO SITIX CO., LTD.**
**1, Higashihama-cho**
**Amagasaki**
**Hyogo(JP)**

(72) Inventor: **Kaneko, Kyojiro**
**c/o Osaka Titanium Co., Ltd.1 Higashihama-cho**
**Amagasaki Hyogo(JP)**
Inventor: **Masuda, Jun-ya**
**c/o Osaka Titanium Co., Ltd.1 Higashihama-cho**
**Amagasaki Hyogo(JP)**

(74) Representative: **Wächtershäuser, Günter, Dr.**
**Tal 29**
**D-80331 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.10/3.09/3.3.3)

## Description

The present invention relates to an apparatus for casting silicon by an electro-magnetic induction.

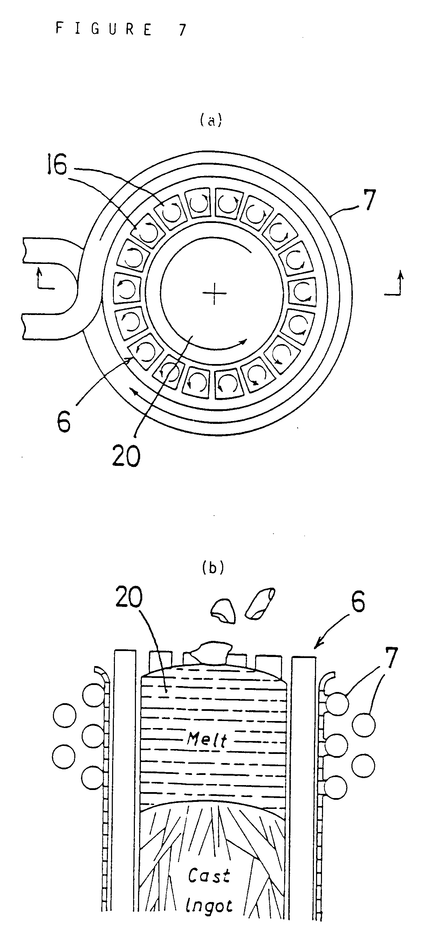

A method, in which an electrically conductive bottomless crucible 6 divided into a plurality of parts in a circumferential direction thereof is placed in an induction coil 7 and a material 20 is gradually drawn downwards from said bottomless crucible 6 with melting within the bottomless crucible 6 to solidify, (hereinafter referred to as the continuous casting by electro-magnetic induction) has been known as one of the continuous casting method by electro-magnetic induction, as shown in Fig. 7.

In the continuous casting method by electro-magnetic induction, since the bottomless crucible 6 is divided into a plurality of parts in the circumferential direction thereof, respective divided parts 16 are electrified by an electric current flowing through an induction coil 7 thereby an electric current is generated in a material 20 within the crucible 6 to heat and melt the material 20 and a repulsion is generated between the electric current flowing through the divided parts 16 of the crucible 6 and the electric current flowing through the material 20 to maintain the material 20 under the condition that it is not brought into contact with the crucible 6.

However, in the continuous casting method by electro-magnetic induction, the molten material 20 within the crucible 6 unavoidably enters gaps 17 between the divided parts 16 of the crucible 6 to solidify. This phenomenon is called the insertion which leads to the difficulty in pulling down the solidified material 20 from the inside of the crucible 6 and the discharge due to the contact of the material, which has been inserted into the gaps between the divided parts 16 of the crucible 6 to solidify, with the electrified crucible surface.

Accordingly, the continuous casting method by electro-magnetic induction has been practically used merely in the form that a slag is put between the crucible 6 and the material 20 within the crucible 6 to continuously charge, melt, pull down and solidify. The continuous casting method by electro-magnetic induction, in which the slag is put between the crucible 6 and the material 20 within the crucible 6, is called the inducto-slag melting method (Note)and has been mainly used for the melting and casting active metals such as titanium. In this method, the slag serves as a cushion material and an insulating material between the crucible 6 and the material 20 within the crucible 6.

On the other hand, an anisotropic solidified silicon lump used as a material for solar cell and the like has been industrially produced by a method in which silicon is molten in a bottomed crucible in an atmosphere inactive to molten silicon and then poured into a mold having an appointed temperature gradient in the vertical direction to solidify.

However, in such the method of casting silicon, the contamination of silicon with impurities from the crucible and mold can not be avoided. In addition, in order to suppress such the contaminations, it is required that the crucible and mold are formed of specially highly pure materials. As a result, this leads to a remarkable increase of casting cost in cooperation with the complexity of heating facilities combined to the mold. Furthermore, the crystallization makes progress at the same time from a bottom surface of the mold and a side surface of the mold, so that such the method is not preferable also in view of the crystallography.

In view of the above described matters, it is thought that the continuous casting method by electro-magnetic induction capable of maintaining the crucible under the condition that it is not brought into contact with the material within the crucible is suitable for the casting of silicon.

The continuous casting method by electro-magnetic induction has been thought for a long time but not practically used in the industrial scale until the inducto-slag melting method is developed in view of the balance against the power source facilities and electric-power cost. However, a small-sized but large-capacity power source facility has been provided as the technology has been remarkably made progress recently to reduce also the electric-power cost. The continuous casting method by electro-magnetic induction is being paid attention again as the method of casting silicon under such the background.

In the continuous casting method by electro-magnetic induction, as above described, the material is not brought into contact with the bottomless crucible and in the case where it is used for the casting of silicon, silicon can be completely prevented from being contaminated with impurities. If silicon is not contaminated with the impurities from the crucible, the grade of the material for the crucible can be lowered thereby the cost of facilities can be remarkably reduced in cooperation with the unnecessity of the mold. Thus, the continuous casting method by electro-magnetic induction can continuously produce a large-sized and high-quality silicon cast lump inexpensively by combining it with the large-capacity power source apparatus. In

(Note) P.G.CLITES and R.A.BEALL: Proc. the Fifth International Conf. on Electro-slag and Special Melting Technology (1975) P477

addition, the crystallization from the side wall of the crucible can be suppressed, so that the continuous casting method by electro-magnetic induction is remarkably preferable also in view of the crystallography.

USA has applied the continuous casting method by electro-magnetic induction for Japanese Patent in view of this way of thinking (JP-A-61052962).

However, the insertion, which has been called in question in the continuous casting method by electro-magnetic induction, is not dissolved by the method disclosed in JP-A-61052962 et all.

In addition, it has been made clear also that in this method the temperature gradient during the cooling after the solidification of silicon is large to generate a great thermal strain in the solidified silicon cast lump and the remained thermal strain leads to the generation of many cracks and crystalline defects in the silicon cast lump thereby the satisfactory quality is not given to the silicon cast lump.

The insertion can be solved by the supply of great electric power but the deterioration due to the thermal strain can not be solved by such the prior art at all to make a fatal disadvantage for a semi-conductor material. In addition, if the insertion is suppressed by the great electric power, the power cost is increased, so that it is desired to suppress the insertion without using the great electric power if possible.

The present invention has been achieved in view of such the circumstances and it is an object of the present invention to provide an apparatus for continuously casting silicon by electro-magnetic induction capable of completely preventing the deterioration due to the thermal strain.

It is another object of the present invention to provide an apparatus for continuously casting silicon by electro-magnetic induction capable of preventing the insertion without using a great electric power in addition to preventing said deterioration.

An apparatus for casting silicon according to the present invention comprises an induction coil, an electrically conductive bottomless crucible, of which at least a part in an axial direction is divided into a plurality of parts in a circumferential direction, disposed within said induction coil and means for heating solidified silicon disposed below a boundary surface level of molten silicon and solidified silicon within said bottomless crucible.

## BRIEF DESCRIPTION OF THE DRAWINGS

Fig. 1 is a longitudinal sectional view illustrating the whole construction of the apparatus according to the present invention;

Fig. 2 is a perspective view showing the example of the construction of the bottomless crucible and heating means which are principal parts of the apparatus according to the present invention;

Fig. 3(A), (B) is a longitudinal sectional view showing other examples of the construction of the heating means;

Fig. 4 is a diagram describing the axial temperature gradient of solidified silicon;

Fig. 5 is a diagram describing the dimensions of the apparatus;

Fig. 6 is a graph quantitatively showing the influences of the width of the gaps between the divided parts of the bottomless crucible and the high-frequency power source output upon the insertion;

Fig. 7(A), (B) is a plan view and a longitudinal sectional view showing the basic principle of the continuous casting method by electro-magnetic induction; and

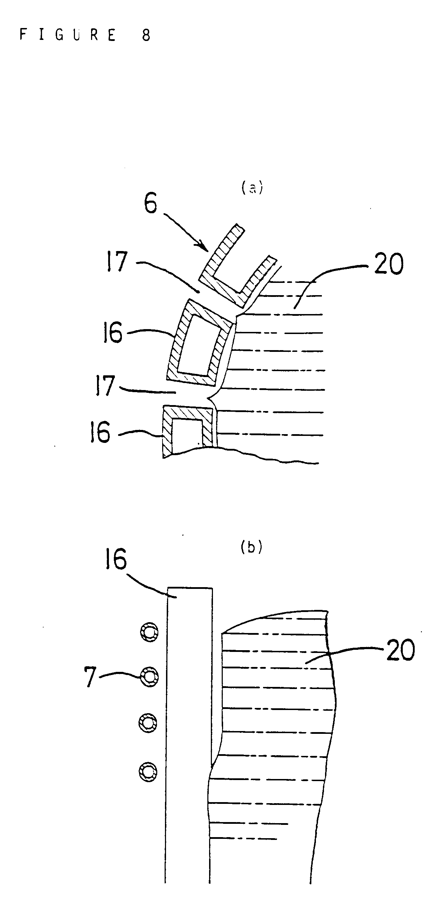

Fig. 8(A), (B) is a cross sectional view and a longitudinal sectional view showing the inserting phenomenon.

In the drawings, 6: Bottomless crucible; 7: Induction coil; 24: Heating means.

With the apparatus for casting silicon according to the present invention, the cooling of a silicon cast lump, which is pulled down from the bottomless crucible, is suppressed by the heating by means of the heating means to give a gradual temperature gradient to the silicon cast lump in the pulling-down direction of the silicon cast lump.

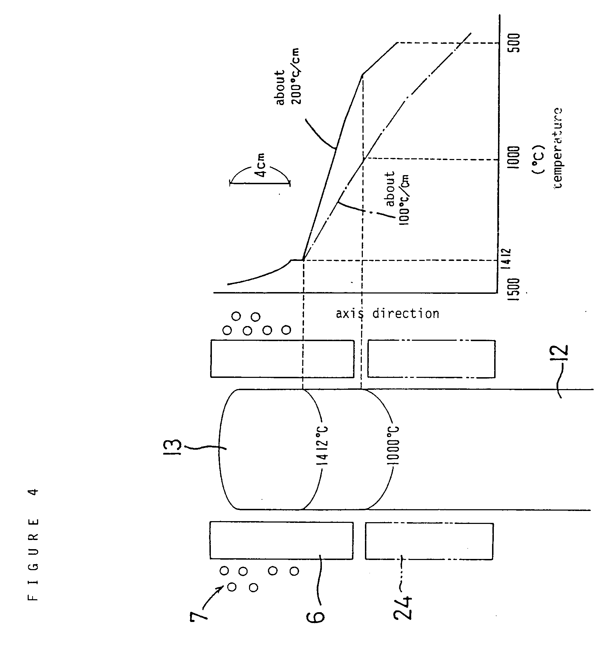

Fig. 4 is a schematical diagram showing an axial temperature distribution of solidified silicon which is pulled down from the bottomless crucible.

A molten silicon 13 within a bottomless crucible 6 is solidified at an almost lower end level of an induction coil 7. A temperature at a boundary surface of molten silicon 13 and solidified silicon 12 is 1,412 °C. Solidified silicon 12 is pulled down from an inside of the bottomless crucible 6 to gradually lower the temperature. A pulling-down speed of solidified silicon 12 is usually 1 to 3 mm/min. In addition, as a rule, in the continuous casting of metals by electro-magnetic induction the cast lump pulled down from the bottomless crucible is compulsorily cooled.

It has been found from the experiments by the present inventor that in the continuous casting of silicon by electro-magnetic induction the axial temperature gradient amounts for about 200 °C/cm even in the case where solidified silicon 12, which is pulled down from the bottomless crucible, is merely cooled naturally, as shown by a full line in a graph, to produce cracks in solidified silicon 12 thereby making the industrial operation impossible. This is greatly influenced by resistance characteristics incidental to silicon.

That is to say, in the case where silicon is subjected to the heating by electro-magnetic induction, silicon shows a lower resistance under the molten condition which means an increased heating efficiency while it shows a higher resistance under the solidified condition which means a reduced heating efficiency. As a result, solidified silicon 12 is rapidly cooled immediately below the boundary surface even within the bottomless crucible 6.

In the apparatus for casting silicon according to the present invention, heating means 24 is disposed below the above described boundary surface and the axial temperature gradient below the boundary surface is reduced, as shown by a two-dotted chain line in the graph, by positively heating a portion below the boundary surface of solidified silicon 12 by means of said heating means 24. As a result, it has been made clear that high-quality solidified silicon 12 having no crack can be continuously casted in the industrial scale.

It is desired that the axial temperature gradient given to solidified silicon 12 by means of the heating means 24 amounts for 100°C/cm or less. In the case where the axial temperature gradient of solidified silicon 12 is reduced to 100°C/cm or less by means of the heating means 24, cracks can be prevented from being generated in solidified silicon 12 of usual size having a square section of which one side is 150 mm or less long. It is required that this temperature gradient is maintained from the boundary surface of molten silicon 13 and solidified silicon 12 to a portion having a temperature of at least 500°C of solidified silicon 12. No crack is generated in portions having temperatures lower than 500°C even though the axial temperature gradient is not specially controlled.

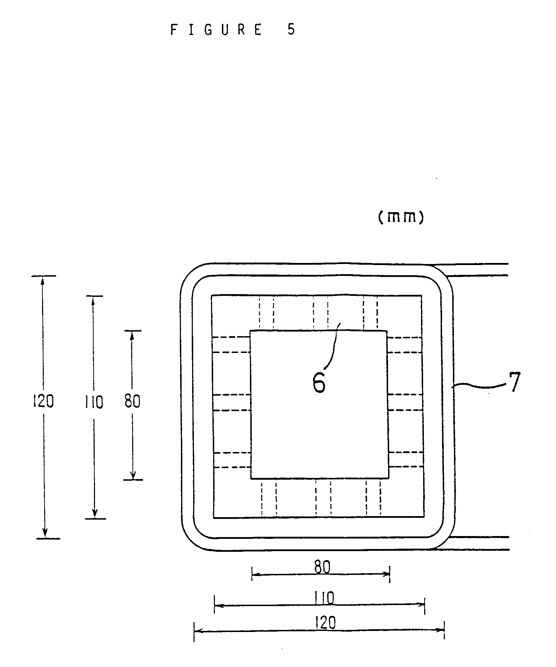

Table 1 shows a relation between the axial temperature gradient in a zone (4.5 to 15 cm long) from the boundary surface to a range of solidified silicon having a temperature of 500°C and casting conditions in the case where silicon is continuously cast by means of the bottomless crucible having a regular square inner section, of which one side is 80 mm long, by the electro-magnetic induction. Other main conditions are as follows (refer to Fig. 5):

```
Bottomless crucible 6

  Inner side surface        Regular square of which
                            one side is 80 mm long

  Outer side surface        Regular square of which
                            one side is 110 mm long

  Height                    250 mm

  Length of slit            200 mm

Induction coil 7

  Inside                    Regular square of which
                            one side is 120 mm long

  Number of turns           6 turns

  Height                    70 mm

Heating means 24

  Inner side surface        Regular square of which
                            one side is 86 mm long

  Height                    100 mm or 200 mm (both

                            are used)

  Radiant body          Molybdenum wire
```

As a result, cracks were frequently generated at the temperature gradient of 160°C/cm or more while the normal silicon cast lump containing no crack was produced at the temperature gradient of 100°C/cm or less.

Table 1

| Temperature gradient (°C/cm) | Casting conditions |
|---|---|
| about 200 | Cracks are generated. |
| about 160 | Cracks are frequently generated but no crack is generated in few cases. |
| about 100 | No crack is generated. |
| about 60 | No crack is generated. |

In addition, in order to reduce the axial temperature gradient of solidified silicon 12, it is required to increase a length of the axial temperature-controlling zone for solidified silicon 12 thereby the casting apparatus is large-sized. Accordingly, it is industrially desired that the temperature gradient amounts for 50°C/cm or more and 25°C/cm or more even in the case of solidified silicon 12 having a large size (having a square section of which one side is 200 to 300 mm long).

5

The direct heating means by electro-magnetic induction can be used as the heating means 24 similarly to the bottomless crucible 6 but its heating efficiency is low, as above described, so that it is rather desired that solidified silicon 12 is heated by the radiant indirect heating means using the radiant bodies formed of graphite, electrically conductive ceramics, high-melting point metals and the like.

In addition, it is desired that the heating means 24 is disposed as closely as possible to the above bottomless crucible 6 to heat solidified silicon 12 from its portion immediately below the boundary surface. It is desired on the basis of the same reason that the slits dividing the circumferential wall of the bottomless crucible 6 into a plurality of parts in the circumferential direction extend to the lower end of the bottomless crucible 6. Such the bottomless crucible 6 has the electro-magnetic induction heating function until the lower end thereof. As a result, solidified silicon 12 is subjected to the electro-magnetic induction heating not only within the bottomless crucible 6 but also after the discharge from the bottomless crucible 6 thereby the temperature distribution within solidified silicon 12 is gradually continued from the heated portion within the bottomless crucible 6 to the portion heated by means of the heating means 24.

In addition, the bottomless crucible 6 may have a hollow structure to flow a coolant through the inside thereof. The bottomless crucible 6 can be formed of inexpensive materials having a relatively lower melting point such as copper by compulsorily cooling the bottomless crucible 6 with the coolant.

In this case, it is preferable that the bottomless crucible 6 excepting the upper portion thereof is divided into parts in the circumferential direction and the inlet pipe and outlet pipe of the coolant are provided in the upper portion, where no division is made, of the crucible. With such the bottomless crucible, the slits dividing the bottomless crucible 6 in the circumferential direction extend to the lower end of the crucible and the number of pipings for introducing, circulating and discharging the coolant can be reduced.

Water is effectively used as the coolant due to its inexpensiveness and superior heat conduction.

It is important in the industrial casting of silicon by the continuous casting method by electro-magnetic induction that the insertion can be prevented without supplying a great electric power in addition to the prevention of cracks from being generated. In addition, even though the insertion can not be suppressed, if the smooth pulling-down of solidified silicon can be secured, the supply of great electric power becomes unrequired. The present inventor continued the investigations about the concrete measures in such the points of view with the knowledge that the control of the gaps between the divided parts in the circumferential direction of the bottomless crucible is effective in the former point of view and the control of the angle of the inner wall surface of the crucible is effective in the latter point of view.

That is to say, if the gaps between the divided parts in the circumferential direction of the bottoless crucible are 1.0 mm or less wide, the electric current flowing through the inner wall surface of the crucible is opposite to the electric current flowing through the superficial portion of molten silicon within the crucible in direction, so that the repulsion generated between both electric currents continuously acts in the gaps between the divided parts thereby the insertion can be effectively suppressed.

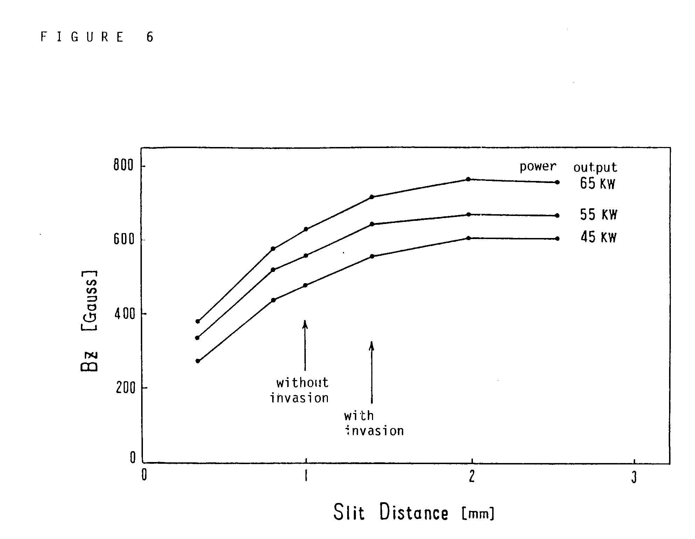

Fig. 6 is a graph showing a relation between the measured values of the central magnetic field within the bottomless crucible for an output loaded to the high-frequency power source apparatus of 30 KHz and the width of the gaps between the divided parts in the case where silicon is continuously cast by means of the bottomless crucible having a regular square inner section, of which one side is 80 mm long, by the electro-magnetic induction. In this case, as shown by an arrow in said graph, no insertion occurs when the width of the gaps between the divided parts is 1.0 mm while the insertion occurs when the width of the gaps between the divided parts amounts for 1.4 mm.

As to the width of the gaps between the divided parts, it was observed that the magnetic field within the crucible was reduced with a reduction of the width of the gaps between the divided parts. This can be understood as follows. The electric current flows merely in the vicinity of the surface within the divided parts of the crucible under the alternating magnetic field. This surface electric current generates a magnetic field in a space also by its own. The magnetic field generated by the surface electric current its own acts as a force generating an electric current in the same direction as that of the electric current flowing through the divided parts of the crucible facing at distances of the gaps between the divided parts. Thus, the electric current within the divided parts of the crucible is biased and as a result, the magnitude of the magnetic field within the crucible is reduced. The same phenomenon as this change of the magnetic field by the gaps between the divided parts is produced also between the inner wall of the crucible and molten silicon. In the range where the gaps between the divided parts are wide (1.4 mm or more), the repulsion between molten silicon and the divided parts of the crucible is reduced. As a result, the insertion of molten silicon into the gaps between the divided parts of the crucible becomes notable.

However, the width of the gaps between the divided parts is less than 0.3 mm, the electric current generated in the divided parts of the crucible rapidly reduces the efficiency of the electric current induced in molten silicon within the crucible, so that the consumption of a needless electric power is brough about thereby leading to the impossibility of the economical melting.

In addition, as shown in Fig. 7(B), it was observed that the insertion became notable in the lower portion of an induction coil 7. It seems that this results from a vertical force applied to molten silicon 20 within the crucible 6 by its own weight which is increased toward the lower portion of molten silicon 20. Accordingly, if the inclination expanding outwards in the downward direction is given to the inner wall surface of the crucible 6, molten silicon 20 can be pulled down even though the insertion is brought about.

Table 2 shows the relation between said angle of inclination and the results of the judgment about the possibility of pulling down the cast lump in the case where silicon having a diameter of 50 mm is continuously cast by the electro-magnetic induction at the width of the gaps between the divided parts of the crucible of 1.0 mm and the standard electric power (45 to 55 kW).

Table 2

| Angle of inclination of the inner wall surface of the crucible | Judgment about the possibility of pulling down the cast lump |
|---|---|
| 0.2° | x (wrong) |
| 0.4° | o (right) |
| 1.0° | o (right) |
| 2.0° | o (right) |
| 5.0° | o (right) |

As obvious from Table 2, if said angle of inclination is 0.4° or more, the cast lump can be pulled down.

However, if said angle of inclination exceeds 2.0°, the diameter of the lower portion of the crucible is excessively increased, so that, when the cast lump-pulling down speed is increased, molten silicon is fallen drop by drop from the solid phase-liquid phase boundary surface on the side surface of the cast lump before molten silicon is solidified thereby the continuous solidification of the cast lump becomes impossible.

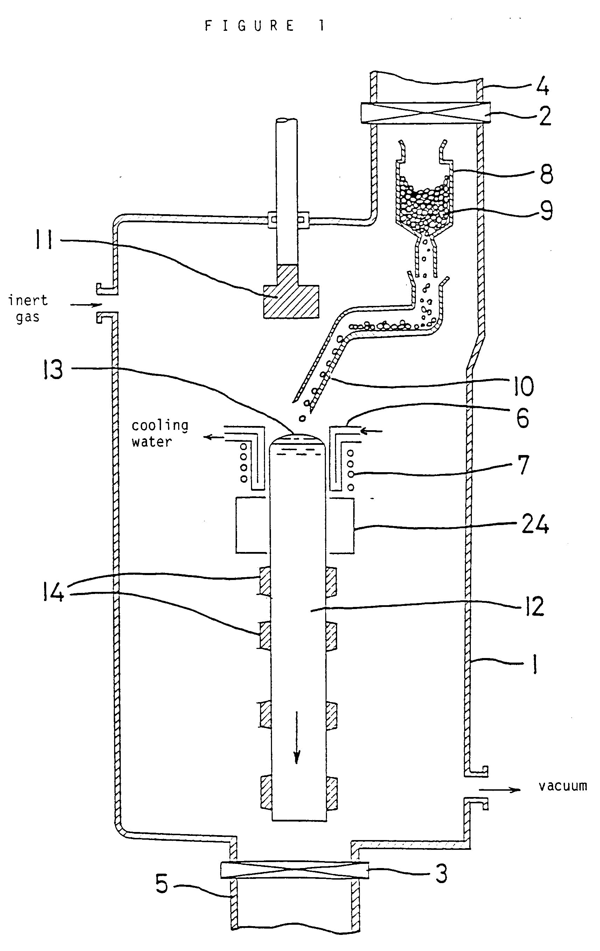

Fig. 1 is a longitudinal sectional view showing a whole construction of one example of an apparatus for casting silicon according to the present invention.

An airtight vessel 1 is a water cooled vessel having a double structure to protect the vessel from the heating therewithin. Said airtight vessel 1 is provided with a vacuum exhaust pump connected thereto through a duct for degassing the inside of the vessel and a supply pipe of inert gases for controlling a partial pressure of said inert gases within the vessel at an optional pressure.

This airtight vessel 1 comprises a material-charging vessel 4 and a cast lump-taking out chamber 5 partitioned by vacuum-cutting off devices 2, 3 provided at an upper portion and lower portion thereof so that the charging of materials and the taking-out of the cast lump may be conducted with maintaining silicon within the airtight vessel 1 in an inert atmosphere.

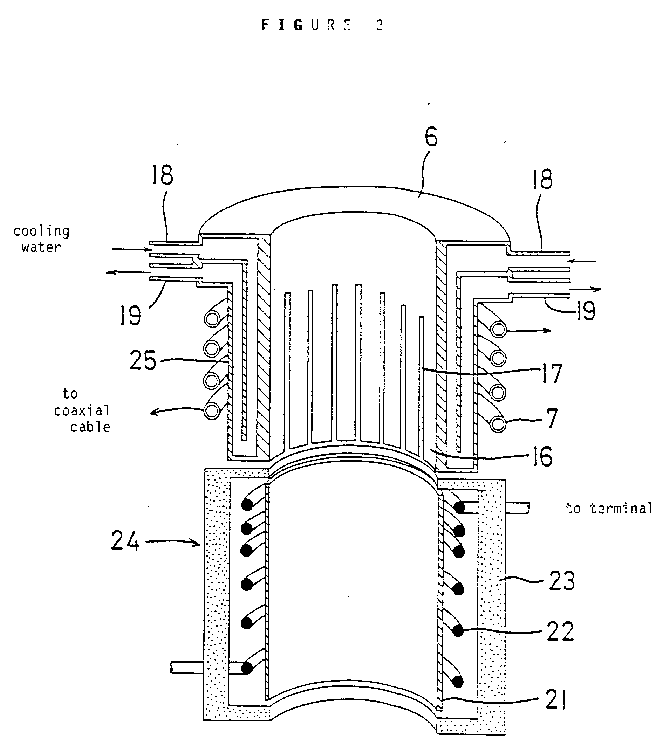

A bottomless crucible 6 fixedly mounted on an almost central portion of the airtight vessel 1 is surrounded by an induction coil 7 and provided with heating means 24 connected to a lower portion thereof. The construction of this portion will be in detail described later with reference to Fig. 2.

A material hopper 8 is provided below the material-charging vessel 4 within the airtight vessel 1 so that granular and lumpy material silicon 9 charged in said hopper 8 may be added in molten silicon 13 within the bottomless crucible through a rotary charging duct 10.

A resistive radiant body 11 formed of graphite and the like is elevatably provided immediately above the bottomless crucible 6 so as to be inserted into the bottomless crucible 6 under the descended condition.

A supporting and drawing device 14 for supporting and pulling down a silicon cast lump 12 is provided below the heating means 24.

A clamp-roll type supporting and drawing device 14 may be used but it is preferable in view of an influence upon the silicon cast lump 12 that a plurality of clamp bodies, which hold the silicon cast lump 12 without slipping and descend by an appointed distance followed by releasing the silicon cast lump 12 and ascending until the original position, are simultaneously driven with shifting in phase.

In addition, it is possible to provide a cutting device for cutting the silicon cast lump 12 by laser beams and the like within the vessel 1.

Fig. 2 shows an example of the construction of the bottomless crucible and the heating means which are principal parts of the apparatus for casting silicon according to the present invention.

The bottomless crucible 6 is formed of a cylindrical member made of copper having such a construction that is divided into a plurality of parts in the circumferential direction excepting an upper portion. An inside of the crucible is partitioned by means of a partition plate 25 to form an inside and an outside so that a coolant, which has been introduced into the crucible through an inlet pipe 18, may descend along the inside portion with circulating in the circumferential direction to cool the inner wall surface and then ascend along the outside portion to be collected in an outlet pipe 19 followed by discharging out of the crucible 6. With the crucible having such the construction, a number of pipings can be reduced thereby the apparatus is economical.

This bottomless crucible 6 has a construction in which a width of gaps between the divided parts 16 formed in the circumferential direction thereof amounts for 0.3 to 1.0 mm or the inner wall surface expands outwards at an angle of 0.4 to 2° in the downward direction or said both conditions are endowed.

Although the bottomless crucible 6 is divided in the circumferential direction excepting the upper portion thereof so as to give the heating function until the lower end thereof in the preferred embodiment shown, a lower portion may be excepted or the crucible may be divided in the circumferential direction all over the axial direction.

In addition, the shape of the bottomless crucible 6 is not limited by a cylindrical one but may be a square cylindrical one. As to also the material, electrically conductive materials other than copper can be used.

The induction coil 7 is concentrically provided outside of the bottoless crucible 6 and connected to a power source via a coaxial cable (not shown). The induction coil 7 and the coaxial cable are cooled by means of the same one cooling channel.

The heating means 24 is concentrically and communicatingly provided below the bottomless crucible 6 and a metallic resistance radiant body 22 is wound around an outside of a cylindrical shelter-plate 21 formed of a silica pipe so that an upper portion may be closely wound in comparison of a lower portion. And, said metallic resistance radiant body 22 is covered by a heat insulating furnace wall 23 mainly comprising alumina.

The radiant body 22 may be divided into a plurality of blocks in the up and down direction so as to be capable of independently controlling the heating.

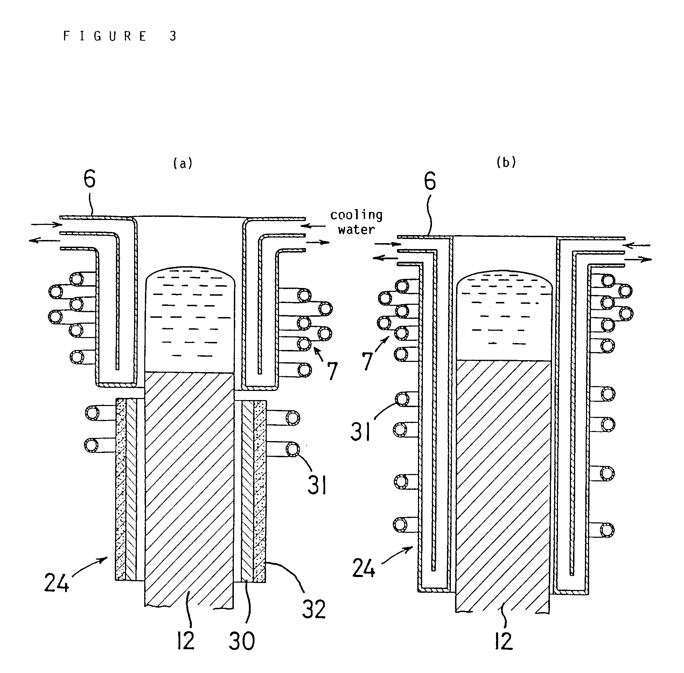

Fig. 3(A), (B) shows other examples of the heating means 24.

The heating means 24 shown in Fig. 3(A) comprises a cylindrical conductor 30 provided concentrically and communicatingly immediately below the bottomless crucible 6 and a second induction coil 31 provided around an outside of said cylindrical conductor 30, an outer surface of the conductor 30 being covered with a heat insulating wall 32. Said second induction coil 31 may be electrified by a power source used also for the induction coil 7 provided in the bottomless crucible 6 or an independent power source. For example, graphite, Ta, Mo and the like are selected as materials for the conductor 30 and for example, graphite, fiber molded body, alumina and the like are used as materials for the heat insulating wall 32.

The heating means 24 shown in Fig. 3(B) is a downward extension of the bottomless crucible 6. Also the second induction coil 31 wound around the extended portion for heating solidified silicon may be electrified by the power source used also for the induction coil 7 or the independent power source in the same manner as in the example shown in Fig. 3(A). In the case where the power source used also for the induction coil 7 is used, it is necessary that the second induction coil 31 can be controlled independently upon the induction coil. In the case where whichever heating means 24 is used, the desired axial temperature gradient is given to silicon immediately after solidified to prevent the thermal strain due to the sudden cooling from being produced.

The concrete procedure of the method of casting silicon by the use of the apparatus shown in Figs. 1 and 2 will be below described.

At first, the inside of the airtight vessel 1 is evacuated and then filled with an argon gas as the inert gases followed by placing a cylindrical seed cast lump formed of silicon by means of the supporting and drawing device 14 so that the upper end of the seed cast lump may be positioned at a center in the direction of height of the bottomless crucible 6.

Next, the radiant body 11 formed of graphite and the like is descended in the bottomless crucible 6 under the condition that the charging duct 10, which is provided above the bottomless crucible 6, is retreated sideways to be settled closely to and immediately above the seed cast lump and then the induction coil 7 is started to be electrified.

If an upper end surface of the seed cast lump within the induction coil 7 is molten, the radiant body 11 being ascended until the original position, and the seed cast lump being ascended within the crucible 6, the initial formation of molten silicon is conducted.

After the initial formation of molten silicon has been conducted, immediately granular material silicon 9 is added to a molten surface of molten silicon 13 through the charging duct 10 to melt material silicon 9 and the supporting and drawing device 14 is operated under the condition that the heating means 24 is operated to pull down the silicon cast lump 12 including the seed cast lump from the bottomless crucible 6 and the heating means 24.

Thus, molten silicon 13 is pulled away in turn from a range receiving the electro-magnetic force to continuously solidify starting from the portion brought into contact with silicon 12 and the desired axial temperature gradient is given to the portion, which has just been solidified, by means of the heating means 24.

A high-quality anisotropic silicon cast lump having no thermal strain can be produced by continuing the above described continuous material-charging, melting and solidifying operation.

The produced silicon cast lump 12 is transferred to the cast lump-taking out chamber 5 by releasing the vacuum-cutting off device 3 and taken out of the cast lump-taking out chamber 5 after the vacuum-cutting off device 3 is closed.

The appointed amount of material silicon 9 is supplied in the hopper 8 from the charging vessel 4 by releasing the vacuum-cutting off device 2 and thereafter the following casting is made preparations by closing the vacuum-cutting off device 2 again.

The results of the actual casting by the above described procedure are below described including those of COMPARATIVE EXAMPLE.

The water-cooled bottomless crucible 6 is made of copper and has a circular sectional shape, an inside diameter of 55 mm, an outside diameter of 85 mm, the number of the divided parts in the circumferential direction of 12, the width of the gaps between the divided parts of 1.0 mm and the height of the divided parts of 150 mm. The inner wall of this bottomless crucible 6 has the inclination expanding outwards at the angle of 0.75° downwards in the axial direction. The induction coil 7 has an inside diameter of 100 mm, an outside diameter of 115 mm and a height of 60 mm. The number of turns of 6 and the induction frequency of 20 KHz were selected. The suitable high-frequency power source output of 45 to 50 KW was used at the continuous pulling-down speed of 1.5 mm/min in the case where silicon is molten and continuously cast.

In addition, the heating means 24 has the construction shown in Fig. 2, that is, the effective heating portion is cylindrical in shape and has an inside diameter of 60 mm and a height of 150 mm so that the temperature at the upper end on the side of the bottomless crucible may be controlled at 1,050°C and the outlet temperature at the lower end may be controlled at 500°C. Thus, the gently-sloping temperature gradient of 40°C/cm from the boundary surface to the lower end of the heating means 24 was given to solidified silicon 12.

Table 2, which was described before, shows the results of the casting under the above described conditions put in order.

In addition, a circular substrate having a diameter of 50 mm and a thickness of 0.35 mm was cut out from the cast lump, which could be pulled down, with the result that the circular substrate was not broken in the midst of cutting operation. This showed that no thermal strain was remained in the cast lump. It was found from the measurement of the diffusion length of this circular semiconductor substrate also that the diffusion length of the P type semiconductor amounted for 200 to 300 microns at 1 ohm cm and thus a polycrystalline semiconductor, which has been produced by the apparatus and method according to the present invention, can be satisfactorily used as a substrate for use in solar cell.

Another preferred embodiment having the construction shown in Fig. 3(A) is below described. The bottomless crucible 6 is made of copper and cooled with water and has a regular square sectional shape of which one side is 80 mm long. The number of the divided parts of 20, the width of the gaps between the divided parts of 1.0 mm, the height of the divided parts of 200 mm from the lower end of the crucible and the angle of inclination expanding downwards of the inner wall of 0.75° were selected. The induction coil 7 incorporated in this bottomless crucible 6 made a regular square loop of which one side on the inner surface was 120 mm long. The number of turns of 6, a height of 70 mm and one side of an outside diameter of 150 mm were selected.

A molten pool of silicon having a regular square section, of which one side was 80 mm long, and a height of 70 mm was formed within the bottomless crucible by electrifying the induction coil 7 with an alternating current having a frequency of 30KHz supplied from the high-frequency power source.

The conductor 30 formed of molybdenum and having a regular square section, one side on the side of inner surface of 86 mm, one side on the side of outer surface of 100 mm and a height of 200 mm was placed immediately below the above described bottomless crucible 6. A graphite molded body having a thickness of 15 mm was wound around the outside of the molybdenum conductor as the heat insulating wall 32. In addition, the second induction coil 31 having an inner regular square section, of which one side is 140 mm long, an outside diameter of 170 mm and a height of 15 mm was wound around the outside of said heat insulating wall 32 with adjusting its height to the upper end of the heating means 24. In the case where the first induction coil 7 was connected to the second induction coil 31 in series and silicon is continuously cast and pulled down at the speed of 1.5 mm/min, the required output was 70 to 80 KW.

In this case, the heating and heat insulating effect for the cast lump by the heating means 24 was such that the surface temperature of the conductor 30 amounts for 1,150 to 1,200°C at the upper end of the heating means 24 and about 500°C at the lower end of the heating means 24 and the gently-inclining temperature gradient of 50°C/cm could be given to solidified silicon 12 from the boundary surface to the lower end of the heating means 24.

Semiconductor characteristics that the diffusion length amounted for 200 to 300 microns were obtained also for the polycrystalline substrate according to the present invention and thus it was found that the polycrystalline substrate according to the present invention can be satisfactorily used as a material for use in solar cell.

The apparatus for casting silicon according to the present invention can produce the high-quality and inexpensive silicon cast lump without producing the thermal strain, which has been fatal to semiconductors, in the continuous casting of silicon by electro-magnetic induction.

In addition, the insertion of silicon into the gaps between the divided parts of the bottomless crucible can be suppressed to such the extent that no difficulty is felt in pulling down solidified silicon without supplying a great electric power by regulating the width of the gaps between the divided parts of the bottomless crucible.

Furthermore, solidified silicon can be smoothly pulled down by giving the inclination to the inner wall surface of the bottomless crucible even though the insertion of silicon is brought about.

As a result, the continuous casting of silicon by electro-magnetic induction can be economically and efficiently conducted in the industrial scale to greatly reduce the casting cost of silicon.

## Claims

1.  An apparatus for casting silicon, comprising an induction coil (7), an electrically conductive bottomless crucible (6), of which at least a part in an axial direction is divided into a plurality of parts (16) in a circumferential direction, disposed within said induction coil (7), characterized by means (24) for heating solidified silicon (12) disposed below a boundary surface level of molten silicon (13) and solidified silicon (12) within said bottomless crucible (6).

2.  An apparatus for casting silicon as set forth in claim 1, characterized in that said heating means (24) is controlled so that a temperature gradient in the axial direction from the boundary surface of said molten silicon (13) and solidified silicon (12) to at least a portion having a temperature of 500°C of solidified silicon (12) may amount for 25°C/cm or more but 100°C/cm or less.

3.  An apparatus for casting silicon as set forth in claim 1 or 2, characterized in that said heating means (24) is a radiation heating means provided below said bottomless crucible (6) in a communicated manner.

4.  An apparatus for casting silicon as set forth in claim 3, characterized in that an exothermic body (22) of said radiation heating means (24) is formed of graphite, high-melting point metal or electrically conductive ceramics.

5.  An apparatus for casting silicon as set forth in any one of claims 1 to 4, characterized in that slits (17) for dividing said bottomless crucible (6) into a plurality of parts (16) extend to a lower end of the bottomless crucible (6).

6.  An apparatus for casting silicon as set forth in any one of claims 1 to 5, characterized in that said bottomless crucible (6) has a hollow structure and is provided with an inlet pipe (18) and an outlet pipe (19) for passing a coolant through an inside thereof.

7.  An apparatus for casting silicon as set forth in claim 6, characterized in that said bottomless crucible (6) excepting an upper part thereof is divided into parts (16) in a circumferential direction and said inlet pipe (18) and outlet pipe (19) of the coolant are mounted on the upper part of the bottomless crucible (6).

8.  An apparatus for casting silicon as set forth in claim 6 or 7, characterized in that said coolant is water.

9. An apparatus for casting silicon as set forth in any one of claims 1 to 8, characterized in that gaps (17) between the circumferentially divided parts (16) of said bottomless crucible (6) have a width of 0.3 to 1.0 mm.

10. An apparatus for casting silicon as set forth in any one of claims 1 to 9, characterized in that an inner wall surface of said bottomless crucible (6) has an inclination expanding outwards at an angle of 0.4 to 2.0° downwards.

**Patentansprüche**

1. Vorrichtung zum Gießen von Silicium, mit einer Induktionsspule (7), einem elektrisch leitenden Tiegel (6) ohne Boden, bei dem mindestens ein Teil in axialer Richtung in mehrere Teile (16) in Umfangsrichtung unterteilt ist, und der innerhalb der Induktionsspule (7) angeordnet ist, **gekennzeichnet durch** eine Einrichtung (24) zum Erhitzen erstarrten Siliciums (12), die unter der Höhe der Grenzfläche zwischen geschmolzenem Silicium (13) und erstarrtem Silicium (12) innerhalb des Tiegels (6) ohne Boden angeordnet ist.

2. Vorrichtung zum Gießen von Silicium gemäß Anspruch 1, dadurch gekennzeichnet, daß die Heizeinrichtung (24) so eingestellt wird, daß der Temperaturgradient in axialer Richtung ausgehend von der Grenzfläche zwischen dem geschmolzenen Silicium (13) und dem erstarrten Silicium (12) bis mindestens in einen Abschnitt mit einer Temperatur von 500°C des erstarrten Siliciums (12) 25°C/cm oder mehr, jedoch 100°C/cm oder weniger beträgt.

3. Vorrichtung zum Gießen von Silicium nach Anspruch 1 oder Anspruch 2, dadurch gekennzeichnet, daß die Heizeinrichtung (24) eine Strahlungsheizeinrichtung ist, die unterhalb des Tiegels (6) ohne Boden in Verbindung mit diesem angeordnet ist.

4. Vorrichtung zum Gießen von Silicium nach Anspruch 3, dadurch gekennzeichnet, daß ein exothermer Körper (22) der Strahlungsheizeinrichtung (24) aus Graphit, hochschmelzendem Metall oder elektrisch leitender Keramik hergestellt ist.

5. Vorrichtung zum Gießen von Silicium nach einem der Ansprüche 1 bis 4, daurch gekennzeichnet, daß sich Schlitze (17) zum Unterteilen des Tiegels (6) ohne Boden in mehrere Teile (16) bis zum unteren Ende des Tiegels (6) ohne Boden erstrecken.

6. Vorrichtung zum Gießen von Silicium nach einem der Ansprüche 1 bis 5, dadurch gekennzeichnet, daß der Tiegel (6) ohne Boden eine Hohlstruktur aufweist und mit einem Einlaßrohr (18) und einem Auslaßrohr (19) versehen ist, um ein Kühlmittel durch seine Innenseite zu leiten.

7. Vorrichtung zum Gießen von Silicium gemäß Anspruch 6, dadurch gekennzeichnet, daß der Tiegel (6) ohne Boden mit Ausnahme seines oberen Abschnitts in Umfangsrichtung in Teile (16) unterteilt ist, und daß das Einlaßrohr (18) und das Auslaßrohr (19) für das Kühlmittel im oberen Abschnitt des Tiegels (6) ohne Boden angebracht sind.

8. Vorrichtung zum Gießen von Silicium nach Anspruch 6 oder Anspruch 7, dadurch gekennzeichnet, daß das Kühlmittel Wasser ist.

9. Vorrichtung zum Gießen von Silicium nach einem der Ansprüche 1 bis 8, dadurch gekennzeichnet, daß Lücken (17) zwischen den in Umfangsrichtung unterteilten Teilen (16) des Tiegels (6) ohne Boden eine Breite von 0,3 bis 1,0 mm aufweisen.

10. Vorrichtung zum Gießen von Silicium nach einem der Ansprüche 1 bis 9, dadurch gekennzeichnet, daß die Innenwandfläche des Tiegels (6) eine Neigung aufweist, die sich nach unten hin mit einem Winkel von 0,4 bis 2,0° aufweitet.

**Revendications**

1. Appareil de coulée de silicium, comprenant une bobine d'induction (7), un creuset sans fond (6) conducteur de l'électricité dont au moins une partie est divisée dans la direction axiale en une série de parties (16) dans la direction périphérique, disposé à l'intérieur de ladite bobine d'induction (7), caractérisé par des moyens (24) pour chauffer le silicium solidifié (12) disposés en-dessous de l'interface limite entre le silicium fondu (13) et le silicium solidifié (12) à l'intérieur dudit creuset sans fond (6).

2. Appareil de coulée de silicium selon la revendication 1, caractérisé en ce que lesdits moyens de chauffage (24) sont réglés de telle sorte que le gradient de température dans la direction axiale, de l'interface limite dudit silicium fondu (13) et dudit silicium solidifié (12) à au moins une partie à une température de 500°C de silicium solidifié (12), puisse être de 25°C/cm ou plus, mais de 100°C/cm ou moins.

3. Appareil de coulée de silicium selon la revendication 1 ou 2, caractérisé en ce que lesdits moyens de chauffage (24) sont constitués de moyens de chauffage par rayonnement installés en dessous dudit creuset sans fond (6) de manière à établir une communication.

4. Appareil de coulée de silicium selon la revendication 3, caractérisé en ce qu'un corps exothermique (22) desdits moyens de chauffage par rayonnement (24) est formé de graphite, de métal à haut point de fusion ou de céramiques conductrices de l'électricité.

5. Appareil de coulée de silicium selon l'une quelconque des revendications 1 à 4, caractérisé en ce que des fentes (17) permettant de diviser ledit creuset sans fond (6) en une série de parties (16) s'étendent jusqu'à l'extrémité inférieure du creuset sans fond (6).

6. Appareil de coulée de silicium selon l'une quelconque des revendications 1 à 5, caractérisé en ce que ledit creuset sans fond (6) a une structure creuse et est équipé d'un tuyau d'entrée (18) et d'un tuyau de sortie (19) pour faire passer un réfrigérant à travers sa partie interne.

7. Appareil de coulée de silicium selon la revendication 6, caractérisé en ce que ledit creuset sans fond (6), à l'exception de sa partie supérieure, est divisé en parties (16) dans la direction périphérique et ledit tuyau d'entrée (18) et ledit tuyau de sortie (19) du réfrigérant sont montés sur la partie supérieure du creuset sans fond (6).

8. Appareil de coulée de silicium selon la revendication 6 ou 7, caractérisé en ce que ledit réfrigérant est de l'eau.

9. Appareil de coulée de silicium selon l'une quelconque des revendications 1 à 8, caractérisé en ce que les intervalles (17) entre les parties (16) séparées sur la périphérie dudit creuset sans fond (6) ont une largeur de 0,3 à 1,0 mm.

10. Appareil de coulée de silicium selon l'une quelconque des revendications 1 à 9, caractérisé en ce que la surface de paroi interne dudit creuset sans fond (6) a une inclinaison s'étendant vers l'extérieur selon un angle de 0,4 à 2,0° vers le bas.

FIGURE 1

FIGURE 2

6

18

18

cooling
water

19

19

25

17

to
coaxial
cable

7

16

to terminal

24

23

22

21

FIGURE 3

(a)    (b)

FIGURE 4

FIGURE 5

(mm)

EP 0 349 904 B1

F I G U R E   7

(a)

(b)

F I G U R E 8

(a)

6

17

20

16

17

16

(b)

16

7

20